# EUROPEAN PATENT APPLICATION

(11) **EP 4 727 297 A1**
(43) Date of publication of application: **15.04.2026**
(21) Application number: 25208362.1
(22) Date of filing: 13.10.2025
(51) Int. Cl.: H10F 19/00, H10F 77/14, H10F 77/00, H10F 19/90

(54) **PHOTOVOLTAIC MODULE**

(30) Priority: 14.10.2024 CN 202411433807
(71) Applicant: JINKO SOLAR CO., LTD., Shangrao, Jiangxi 334100 (CN); ZHEJIANG JINKO SOLAR CO., LTD., Haining, Zhejiang 314416 (CN)
(72) Inventor: TAO, Wusong, SHANGRAO 334100 (CN); WANG, Luchuang, SHANGRAO 334100 (CN); HAN, Xiangchao, SHANGRAO 334100 (CN); ZHU, Lei, SHANGRAO 334100 (CN)
(74) Representative: DREISS Patentanwälte PartG mbB

(57) **Abstract**

The present disclosure provides a photovoltaic module. The photovoltaic module includes three cell string groups (11, 12, 13) connected in series, the three cell string groups each include four cell strings (14) in parallel. The cell string (14) includes multiple electrically connected cells (15), which are quarter cells cut from the whole cell. Among them, the length L1 of the cell is 182.3mm, and the width L2 of the cell satisfies 46.675mm < L2 < 53.25mm. The photovoltaic module adopts a four in four circuit design, which means that the cells (15) are quarter cells cut from the whole cell, and each cell string group (11-13) includes four parallel cell strings (14). This not only reduces the current in a single cell string and lowers the power loss of a single cell string, but also avoids the overall output current of the photovoltaic module caused by the use of cut cells. This ensures that the overall output current of the photovoltaic module in this embodiment is equal to that of the conventional photovoltaic module using two-piece cells, ensuring the overall power of the photovoltaic module in the present disclosure.

## Description

### TECHNICAL FIELD

The present disclosure relates to the field of photovoltaic technology, and in particular, to a photovoltaic module.

### BACKGROUND

With the development of technologies, application range of photovoltaic modules has become increasingly wide, and power of photovoltaic modules is also increasing. In order to improve output power of photovoltaic modules, size of the solar cells in photovoltaic modules is also gradually increasing. Photovoltaic modules usually adopt half cells, and the current of a single string of cells is relatively high, resulting in a significant overall power loss of the photovoltaic module.

### SUMMARY

In view of this, the present disclosure provides a photovoltaic module to solve the technical problem of high current in a single cell string and high overall power loss in photovoltaic modules in the related art.

The present disclosure provides a photovoltaic module. The photovoltaic module includes three cell string groups connected in series, and each of the three cell string groups includes four cell strings connected in parallel; the cell string includes cells electrically connected, which are quarter cells cut from a whole cell; a length L1 of the cell is 182.3mm, and a width L2 of the cell satisfies 46.675mm ≤ L2 ≤ 53.25mm.

In the embodiments, the cells in the photovoltaic module are cut into quarter cells cut from a whole cell, in order to reduce the area of the cells, thereby shortening the current circuit on the cells and reducing the internal power loss of the cells, thus enabling an increase in the output power of the photovoltaic module. Moreover, compared with the photovoltaic module with two in parallel and six in series, the photovoltaic module provided by the present disclosure adopts a cut-four-and-parallel-four circuit design. That is, the cell is a quarter cell cut from a whole cell, and each cell string group includes four cell strings connected in parallel. This not only reduces the current in a single cell string and lowers the power loss of a single cell string, but also avoids the overall output current of the photovoltaic module caused by the use of cut cells, so that the overall output current of the photovoltaic module of the embodiments of the present disclosure is equal to that of the conventional photovoltaic module using two-piece cells, ensuring the overall power of the photovoltaic module of the embodiments of the present disclosure. Meanwhile, the cell can have a length L1 of 182.3mm, and a width L2 within a range of 46.675mm ≤ L2 ≤ 53.25mm, in order to ensure that the string length of the battery string formed by multiple cells can meet the creep distance required by the photovoltaic module, and guarantee the normal use of the photovoltaic module.

In some embodiments of the present disclosure, in which a number of solar cells in each cell string is the same.

In some embodiments of the present disclosure, the four cell strings in each of the three cell string groups are arranged in an array along a length direction of the photovoltaic module and a width direction of the photovoltaic module, respectively.

In some embodiments of the present disclosure, two cell strings that are adjacent to each other along the length direction of the photovoltaic module are electrically connected to each other through a first busbar; in which the three cell string groups include a first cell string group, a second cell string group, and a third cell string group; and the photovoltaic module further includes a second busbar and a third busbar, the first cell string group and the second cell string group are connected in series through the second busbar and the third busbar; and in which along the length direction of the photovoltaic module, the photovoltaic module further includes a fourth busbar and a fifth busbar, two ends of the third cell string group are respectively electrically connected to the fourth busbar and the fifth busbar, and both the fourth busbar and the fifth busbar are electrically connected to the first bustbar located in the first cell string group or the second cell string group.

In some embodiments of the present disclosure, a first lead wire is further provided between the second cell string group and the third cell string group, in which the first lead wire is electrically connected to the fourth busbar and the fifth busbar, and the first lead wire is also electrically connected to the first busbar located in the second cell string group.

In some embodiments of the present disclosure, a second lead wire is further provided between the first cell string group and the second cell string group; and the second lead wire is electrically connected to the second busbar and the third busbar; wherien the photovoltaic module further includes a first bypass diode, a second bypass diode, and a third bypass diode; and the first cell string group is connected in reverse parallel with the first bypass diode through the second lead wire, the second cell string group is connected in reverse parallel with the second bypass diode through the second lead wire, and the third cell string group is connected in reverse parallel with the third bypass diode through the first lead wire.

In some embodiments of the present disclosure, a first insulation layer is provided between the first lead wire and the cell, and a second insulation layer is provided between the second lead wire and the cell.

In some embodiments of the present disclosure, a surface area of the first insulation layer is greater than a surface area of the first lead wire, and a surface area of the second insulation layer is greater than a surface area of the second lead wire.

In some embodiments of the present disclosure, along a width direction of the photovoltaic module, a spacing L3 between adjacent cell strings satisfies 1.4mm ≤ L3 ≤ 1.6mm; and along a length direction of the photovoltaic module, adjacent solar cells have an overlapping area, and a length L4 of the overlapping area satisfies 0.2 mm ≤ L4 ≤ 0.4 mm.

In some embodiments of the present disclosure, the photovoltaic module further includes electrode lines and the busbar are electrically connected to each other through the electrode lines on adjacent cell strings along the width direction of the photovoltaic module in each of the three cell string groups are arranged on a same side of the solar cell along a thickness direction of the photovoltaic module.

It should be understood that the general description provided above and the detailed description in the following text are merely illustrative and do not limit this application.

### BRIEF DESCRIPTION OF DRAWINGS

In order to more clearly illustrate technical solutions of embodiments of the present disclosure, the accompanying drawings used in the embodiments are briefly described below. The drawings described below are merely a part of the embodiments of the present disclosure. Based on these drawings, those skilled in the art can obtain other drawings without creative labor.
FIG. 1 is a schematic diagram of a structure of a photovoltaic module provided by some embodiments of the present disclosure;
FIG. 2 is a structural schematic diagram of a cell shown in FIG. 1 provided by some embodiments of the present disclosure;
FIG. 3 is a structural schematic diagram of a first cell string shown in FIG. 1 provided in the embodiment of the present disclosure;
FIG. 4 shows a structural schematic diagram of a circuit of the photovoltaic module provided by some embodiments of the present disclosure;
FIG. 5 is a sectional view of FIG. 1;
FIG. 6 is a structural schematic diagram of the second lead wire and the first busbar shown in FIG. 1 provided by some embodiments of the present disclosure;
FIG. 7 is a top view of FIG. 6;
FIG. 8 is a structural schematic diagram of the second lead wire shown in FIG. 6 provided by some embodiments of the present disclosure;
FIG. 9 is a structural schematic diagram of the second lead wire shown in FIG. 6 provided by some embodiments of the present disclosure;
FIG. 10 is a structural schematic diagram of the second lead wire shown in FIG. 6 provided by some embodiments of the present disclosure;
FIG. 11 is a structural schematic diagram of the first lead wire and the first busbar shown in FIG. 6 provided by some embodiments of the present disclosure; and
FIG. 12 is a structural schematic diagram of the first lead wire and the first busbar shown in FIG. 6 provided by some embodiments of the present disclosure.

Reference signs:
1- Photovoltaic modules;
11- First cell string group;
12- Second cell string group;
13- Third cell string group;
14- Cell string;
15- Cell;
16- First busbar;
161- lead-out end;
17- Second busbar;
18- Third busbar;
19- Fourth busbar;
20- Fifth busbar;
21- First lead wire;
22- Second lead wire;
221- lead-out wire;
23- First bypass diode;
24- Second bypass diode;
25- Third bypass diode;
26- Electrode line;
27- First insulation layer;
28- Second insulation layer.

### DESCRIPTION OF EMBODIMENTS

In order to better understand technical solutions of the present disclosure, the embodiments of the present disclosure are described in details with reference to the drawings.

It should be clear that the described embodiments are merely part of the embodiments of the present disclosure rather than all of the embodiments. All other embodiments obtained by those skilled in the art without paying creative labor shall fall into the protection scope of the present disclosure.

The terms used in the embodiments of the present disclosure are merely for the purpose of describing specific embodiment, rather than limiting the present disclosure. The terms "a", "an", "the" and "said" in a singular form in the embodiment of the present disclosure and the attached claims are also intended to include plural forms thereof, unless noted otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

A photovoltaic module can convert light energy into electrical energy through crystalline silicon PN junction semiconductors, and can be widely used in large-scale ground power stations, roofs, ships, aviation and other fields. The photovoltaic module includes multiple cell strings, which are connected in series and parallel. In the conventional photovoltaic module, generally, six cell strings are connected in series to form a cell string group, and then two cell string groups are connected in parallel (i.e. two in parallel and six in series). The cell in the cell string are a half cell formed by cutting a whole cell. An area of the cell in the photovoltaic module is relatively large, and the internal power loss of the cell is large during use, resulting in a decrease in the overall power of the photovoltaic module.

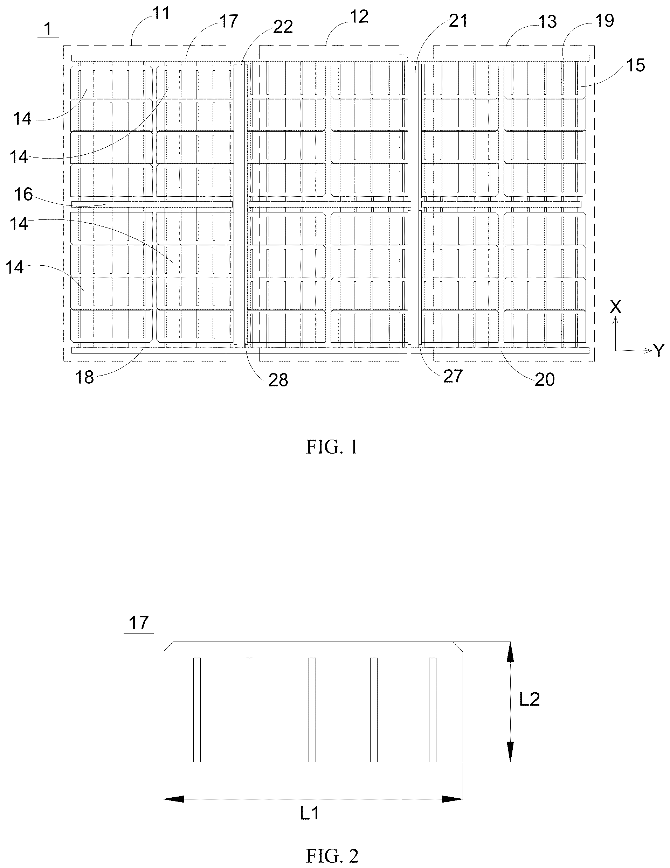

To solve the above technical problems, as shown in the FIG. 1, the present disclosure provides a photovoltaic module 1. The photovoltaic module 1 may include three cell string groups connected in series, each of which includes four cell strings 14 connected in parallel. The cell string 14 includes multiple cells 15 electrically connected, which are quarter cells cut from a whole cell.

In this embodiment, the solar cell 15 in the photovoltaic module 1 is cut into quarter cells 15 by cutting the entire solar cell to reduce the area of the solar cell 15, so that the current circuit on the solar cell 15 is shortened, and the internal power loss of the solar cell 15 is reduced, thereby improving the output power of the photovoltaic module 1. Compared to the photovoltaic module with two-parallel-six-strings mentioned above, the photovoltaic module 1 provided in the embodiments of the present disclosure adopts a cut-four-and-parallel-four circuit design (i.e., the cell 15 is a quarter cell 15 cut from a whole cell, and each cell string group includes four cell strings 14 connected in parallel). This not only reduces the current in a single cell string 14 and lowers the power loss of a single cell string 14 but also avoids the overall output current of the photovoltaic module 1 caused by the use of cut cells 15, so that the overall output current of the photovoltaic module 1 of the embodiments of the present disclosure is equal to that of the conventional photovoltaic module using two-piece cells, ensuring the overall power of the photovoltaic module 1 of the embodiments of the present disclosure.

Compared to the conventional photovoltaic module designed with a two-parallel-six-strings circuit, in the photovoltaic module 1 of the present disclosure, the magnitude of current in a single cell string 14 is half of the magnitude of current in a single cell string of the conventional photovoltaic module, so that the power loss of a single cell string 14 is reduced by 3/4, and the overall power of the photovoltaic module 1 is increased by at least 5 watts.

The types of cells 15 in the embodiments of the present disclosure include, but are not limited to Passivated Emitting electrode Rear Cell (PERC), Tunnel Oxide Passivated Contact (TOPCON), Heterojunction with Intrinsic Thin layer (HIT), Back Contact (BC), Perovskite Solar Cells (PSC), etc. There is no limitation on the types of cells in the photovoltaic module 1 in this embodiment.

For the BC cell, an emitting electrode, a surface field, and a metal electrode are all arranged on the back of the BC cell, with cross indication distribution. The front of cell adopts SiNx/SiOx double-layer anti-reflection passivation film, so that the front of the cell is not blocked by the metal electrode, and the cell can receive more incident light, thereby reducing optical losses, and improving photoelectric conversion efficiency.

For the TOPCon cell, along their thickness direction, the TOPCon cell sequentially includes a metal silver electrode, a front surface silicon nitride passivation layer, a boron doped emitting electrode, an N-type base silicon layer, a diffusion doped layer, ultra-thin silicon oxide, doped polycrystalline silicon, silicon nitride, and a metal silver electrode. The back of the cell is composed of an ultra-thin silicon oxide layer (1nm~2nm) and a layer of phosphorus doped microcrystalline amorphous mixed Si film, which together form a passive contact structure. This structure can block the recombination of minority carrier holes, and improve the open circuit voltage and short-circuit current of the cell. The ultra-thin oxide layer can enable majority carrier electrons to tunnel into the polycrystalline silicon layer while blocking the recombination of minority carrier holes. The excellent passivation effect of ultra-thin silicon oxide and heavily doped silicon film causes the surface energy bands of silicon wafers to bend, thereby forming a field passivation effect. The probability of electron tunneling increases significantly, the contact resistance decreases, and the open circuit voltage and short-circuit current of the cell are improved, thereby enhancing the conversion efficiency of the cell.

For the HIT cell, along its thickness direction, the HIT cell sequentially includes a front low-temperature silver electrode, a front conductive film, an N-type amorphous silicon film, an intrinsic amorphous silicon film, an N-type base silicon layer, an intrinsic amorphous silicon film, a P-type amorphous silicon film, a back conductive film, and a back low-temperature silver electrode.

For the PERC cell, along its thickness direction, the PERC cell sequentially includes a front surface metal silver electrode, a front surface silicon nitride passivation layer, a phosphorus layer emitting electrode, a P-type base silicon layer, a local aluminum back field, a metal aluminum back electrode, and a back passivation layer (Al₂O₃/SiNx). The PERC cell adopts a passivation film to passivate the back by replacing all-aluminum back field, enhancing the internal back reflection of light on the silicon substrate, reducing the recombination rate of the back, and increasing the efficiency of the cell by 0.5% to 1%.

For the PSC cell, along its thickness direction, the perovskite cell sequentially includes a substrate material, a conductive thin film, an electron transport layer (titanium dioxide), a perovskite absorption layer (hole transport layer), and a metal cathode. The perovskite material has high light absorption coefficient and long carrier diffusion distance. The photons absorbed by the perovskite material are converted into electrons, which are easily collected by the electrode with small loss. Therefore, it can generate high photovoltaic voltage and current, making perovskite exhibit high photoelectric conversion efficiency.

In the above embodiments, as shown in FIG. 1 and FIG. 2, the length L1 of the cell 15 can be 182.3 mm, and the width L2 of the cell 15 can satisfy 46.675 mm ≤ L2 ≤ 53.25 mm, so that the string length of the cell string 14 formed by multiple cells 15 can satisfy the required creepage distance of the photovoltaic module 1, ensuring the normal use of the photovoltaic module 1.

The photovoltaic module 1 can include but is not limited to a first type photovoltaic module 1 with a length of 2382 mm and a width of 1134 mm, or a second type photovoltaic module 1 with a length of 2278 mm and a width of 1134 mm. The size of the cell 15 in the first type photovoltaic module 1 can be L1=182.3mm, and L2=53.25 mm. The size of the cell 15 of the second type photovoltaic module 1 can be L1=182.3 mm, and L2=46.675 mm.

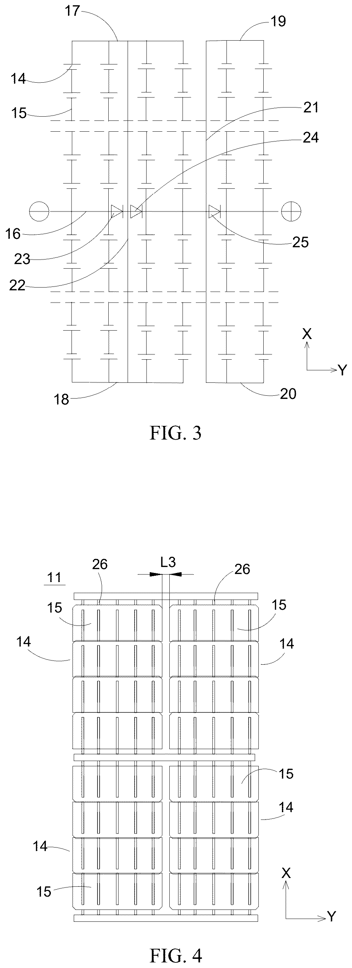

As shown in FIG. 1 and FIG. 3, in some embodiments of the present disclosure, two adjacent cell strings 14 along the length direction X of the photovoltaic module 1 are electrically connected through a first busbar 16. The three cell string groups include a first cell string group 11, a second cell string group 12, and a third cell string group 13.

The photovoltaic module 1 further includes a second busbar 17 and a third busbar 18. The first cell string group 11 and the second cell string group 12 are connected in series through the second busbar 17 and the third busbar 18 along the length direction X of the photovoltaic module 1. The photovoltaic module 1 further includes a fourth busbar 19 and a fifth busbar 20. The two ends of the third cell string group 13 are electrically connected to the fourth busbar 19 and the fifth busbar 20 respectively, and both the fourth busbar 19 and the fifth busbar 20 are electrically connected to the first bustbar 16 located in the first cell string group 11 or the second cell string group 12.

In some embodiments, along the length direction X of the photovoltaic module 1, a second busbar 17 and a third busbar 18 are provided at both ends of the first cell string group 11 and the second cell string group 12, so that the two ends of the first cell string group 11 and the second cell string group 12 are electrically connected to the second busbar 17 and the third busbar 18, respectively, thereby achieving the series connection of the first cell string group 11 and the second cell string group 12. Meanwhile, along the length direction X of the photovoltaic module 1, the fourth busbar 19 and the fifth busbar 20 located at both ends of the third cell string group 13 are electrically connected to the first bustbar 16 located in the first cell string group 11 or the second cell string group 12, thereby achieving the series connection of the first cell string group 11, the second cell string group 12, and the third cell string group 13.

In some embodiments of the present disclosure, as shown in FIG. 1 and FIG. 3, a first lead wire 21 is also provided between the second cell string group 12 and the third cell string group 13. The first lead wire 21 is electrically connected to the fourth busbar 19 and the fifth busbar 20, and is also electrically connected to the first bustbar 16 located in the second cell string group 12.

In this embodiment, a first lead wire 21 is provided between the second cell string group 12 and the third cell string group 13 to electrically connect the fourth busbar 19 and the fifth busbar 20, and the first lead wire is also electrically connected to the first bustbar 16 located in the first cell string group 11, thereby achieving a series connection between the third cell string group 13 and the second cell string group 12, and thus achieving a series connection between the first cell string group 11, the second cell string group 12, and the third cell string group 13.

As shown in FIG. 1 and FIG. 3, in some embodiments of the present disclosure, a second lead wire 22 is also provided between the first cell string group 11 and the second cell string group 12. The second lead wire 22 electrically connects the second busbar 17 and the third busbar 18. The photovoltaic module 1 further includes a first bypass diode 23, a second bypass diode 24, and a third bypass diode 25. The first cell string group 11 is connected in reverse parallel with the first bypass diode 23 through the second lead wire 22, the second cell string group 12 is connected in reverse parallel with the second bypass diode 24 through the second lead wire 22, and the third cell string group 13 is connected in reverse parallel with the third bypass diode 25 through the first lead wire.

In this embodiment, a second lead wire 22 is provided between the first cell string group 11 and the second cell string group 12 to electrically connect the second busbar 17 and the third busbar 18, so that the first bypass diode 23 can be connected in reverse parallel with the first cell string group 11 through the second lead wire 22 (i.e., the first bypass diode 23 is connected in parallel with the first cell string group 11, but with opposite polarity). When the cell 15 on any cell string 14 in the first cell string group 11 is blocked or have a faulty, a hot spot effect occurs (i.e., some cells in the photovoltaic module have a short-circuit current smaller than the operating current of the module due to obstruction, fragmentation, etc., causing these cells to be in a reverse biased state and consuming energy generated in other areas), the first bypass diode 23 can form a forward bias, allowing current to bypass the blocked or faulty cell string 14 and flow through the first bypass diode 23, without affecting the normal power generation of other cell strings 14 within the first cell string group 11.

The second cell string group 12 is connected in reverse parallel with the second bypass diode 24 through the second lead wire 22 (i.e., the second bypass diode 24 is connected in parallel with the second cell string group 12, but with opposite polarity). When the cell 15 on any cell string 14 in the second cell string group 12 is blocked or have a faulty, a hot spot effect occurs, the second bypass diode 24 can form a forward bias, allowing current to bypass the blocked or faulty cell string 14 and flow through the second bypass diode 24, without affecting the normal power generation of other cell strings 14 in the second cell string group 12.

Meanwhile, the third cell string group 13 is connected in reverse parallel with the third bypass diode 25 through the second lead wire 22 (i.e., the third bypass diode 25 is connected in parallel with the third cell string group 13, but with opposite polarity). When the cell 15 on any cell string 14 in the third cell string group 13 is blocked or have a faulty, a hot spot effect occurs, the third bypass diode 25 can form a forward bias, allowing current to bypass the blocked or faulty cell string 14 and flow through the third bypass diode 25, without affecting the normal power generation of other cell strings 14 in the third cell string group 13.

The first lead wire 21 and the second lead wire 22 can be connected to the busbar by soldering, but not limited to soldering.

As shown in FIG. 1 and FIG. 3, in some embodiments of the present disclosure, the number of cells 15 in each cell string 14 is the same, so that the number of cells 15 in the three cell string groups is the same, and thus the number of cells 15 protected by the three bypass diodes is the same, which can improve the working stability of the three bypass diodes and enhance the protection effect of the three bypass diodes for the photovoltaic module 1.

In this embodiment, since the first lead wire and the second lead wire play the role of electrical connection, they are usually formed by conductive materials as conductors. During the assembling of the photovoltaic module, the gap between adjacent cell string groups is relatively small. The surface area of the first lead wire and the second lead wire is usually larger than the gap area between the connected cell string groups, causing the first lead wire or the second lead wire to overlap with part of the structure of the cells when it is arranged on the photovoltaic module. The direct contact between the first lead wire or the second lead wire and the cells is likely to cause a short circuit, affecting the normal operation of the photovoltaic module.

To solve the above technical problems, as shown in FIG. 1 and FIG. 3, in this embodiment, a first insulation layer 27 can be provided between the first lead wire 21 and the cell 15, and a second insulation layer 28 can be provided between the second lead wire 22 and the cell 15. The first lead wire 21 and the cell 15, as well as the second lead wire 22 and the cell 15, can be separated by setting the first insulation layer 27 and the second insulation layer 28, avoiding short circuit phenomena and improving the safety of the photovoltaic module 1.

In this embodiment, the surface area of the first insulation layer 27 is larger than the gap area between adjacent cells 15, so that part of the structure of the first insulation layer 27 can abut with the cells 15, thereby providing support for the first insulation layer 27. And the surface area of the second insulation layer 28 is larger than the gap area between adjacent cells 15, so that part of the structure of the second insulation layer 28 can abut with the cells 15, thereby providing support for the second insulation layer 28.

Meanwhile, the surface area of the first insulation layer 27 can be larger than the surface area of the first lead wire 21, and the surface area of the second insulation layer 28 can be larger than the surface area of the second lead wire 22. Making the surface area of the first insulation layer 27 larger than the surface area of the first lead wire 21 can further improve the separation effect of the first insulation layer 27 on the first lead wire 21 and the cells 15, and making the surface area of the second insulation layer 28 larger than the surface area of the second lead wire 22 can further improve the separation effect of the second insulation layer 28 on the second lead wire 22 and the cells 15, thereby significantly improving the safety of the photovoltaic module 1.

In each of the above embodiments, as shown in FIG. 1 and FIG. 4, along the width direction Y of the photovoltaic module 1, the spacing L3 between adjacent cell string groups 14 satisfies 1.4mm ≤ L3 ≤ 1.6mm, to avoid the sliding of the cells 14 in the assembling or transportation procedures of the photovoltaic module 1, causing the connected cell string groups 14 to collide and be damaged. The specific value of the spacing L3 between adjacent cell string groups 14 can be 1.4 mm, 1.5 mm, 1.6 mm, etc.

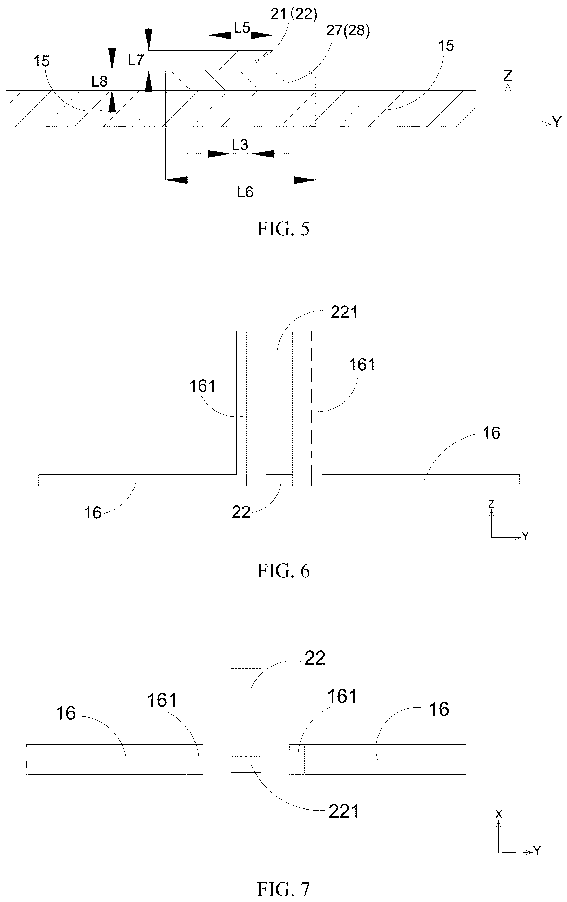

In each of the above embodiments, as shown in FIG. 5, along the width direction Y of the photovoltaic module, the width L5 of the first lead wire 21 and the second lead wire 22 satisfies 4mm ≤ L5 ≤ 8mm, which can improve the discharging capacity of the first lead wire 21 and the second lead wire 22, and avoid the excessive overlapping area between the first lead wire 21/the second lead wire 22 and the cells 15 which affects the lamination process. The specific value of L5 can be 4 mm, 6 mm, 8 mm, etc. And along the thickness direction Z of the photovoltaic module, the thickness L7 of the first lead wire 21 and the second lead wire 22 satisfies 0.15 mm ≤ L7 ≤ 0.4 mm, to avoid the large size of the protrusion of the first lead wire 21 and the second lead wire 22 due to excessive thickness, which increases the possibility of the first lead wire 21 and the second lead wire 22 squeezing the cells 15 during the lamination process and causing damage to the cells 15. The specific value of L7 can be 0.15 mm, 0.25 mm, 0.4 mm, etc.

Meanwhile, in the width direction Y of the photovoltaic module, the width L6 of the first insulation layer 27 and the second insulation layer 28 satisfies 8 mm ≤ L6 ≤ 18 mm, enabling the insulation layers to completely separate the leads from the photovoltaic cells 15, enhancing the safety of the photovoltaic module, and making the width of the insulation layers larger, which can increase the contact area between the insulation layers and the photovoltaic cells 15, improving the installation stability and reliability of the insulation layers. The specific values of L6 can be 8 mm, 12 mm, 15 mm, 18 mm, etc. In the thickness direction Z of the photovoltaic module, the thickness L8 of the first insulation layer 27 and the second insulation layer 28 satisfies 0.15 mm ≤ L8 ≤ 0.25 mm. While avoiding the influence on the laminating process due to excessive thickness of the insulation layer, it can also meet the required insulation performance. The specific values of L8 can be 0.15 mm, 0.20 mm, 0.25 mm, etc.

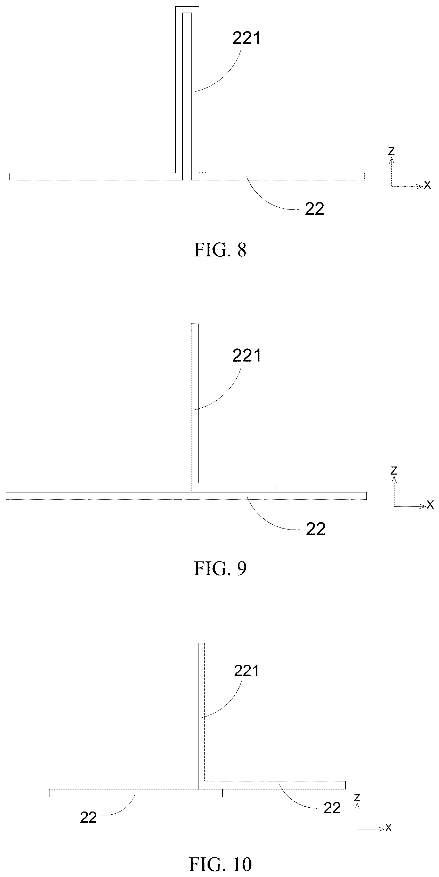

In the above embodiments, as shown in FIG. 6 and FIG. 7, first busbar 16 is further provided with a lead-out end 161 perpendicular to the first busbar 16, and the lead-out end 161 is in an "L" shape relative to the first busbar 16. On the second lead wire 22, there is also a lead-out line 221 perpendicular to the second lead wire 22, and the first bypass diode and the second bypass diode are respectively arranged on the two sides of the lead-out line 221 along the width direction Y of the photovoltaic module, and are all connected to the lead-out end 161. The lead-out line 221 can have three layout forms as shown in FIG. 8 to FIG. 10.

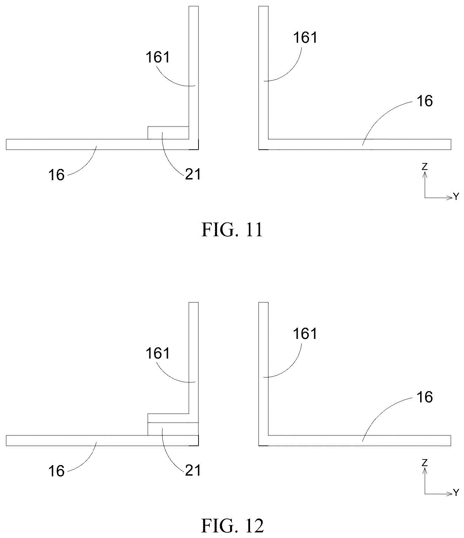

In the above embodiments, as shown in FIG. 11 and FIG. 12, the first lead wire 21 is electrically connected to the first busbar 16 in the second cell string group to achieve the series connection of the third cell string group and the second cell string group. The lead-out end 161 of the first busbar 16 in the second cell string group has two layout forms. Specifically:

The first layout form is as shown in FIG. 11, the first busbar 16 and the lead-out end 161 in the second cell string group are an integrally formed structure. Along the thickness direction Z of the photovoltaic module, the first lead wire 21 is located on the upper surface of the first busbar 16 and abuts with the side wall of the lead-out end 161.

The second layout form is as shown in FIG. 12, first busbar 16 and the lead-out end 161 in the second cell string group are a separate structure. Along the thickness direction Z of the photovoltaic module, the first lead wire 21 is located between the lead-out end 161 and the first busbar 16.

In the above embodiments, a third bypass diode is electrically connected between two adjacent lead-out ends 161.

Meanwhile, along the length direction X of the photovoltaic module 1, there is an overlapping area between adjacent cells 15 in the cell string 14, so that more cells 15 can be placed in the cell string 14 and the efficiency of the cell string 14 can be improved. The length L4 of the overlapping area satisfies 0.2mm ≤ L4 ≤ 0.4mm, for example, L4 can be 0.2 mm, 0.3 mm, 0.4 mm, and so on. L4 should not be too large or too small. When it is too small, the overlapping area between adjacent cells 15 along the length direction X of the photovoltaic module 1 is too small, so that it is impossible to add more cells 15 to the cell string 14, resulting in a small improvement in the efficiency of the cell string 14. When it is too large, the overlapping area between adjacent cells 15 along the length direction X of the photovoltaic module 1 is too large, resulting in a large area of mutual obstruction between the cells 15, which has little effect on the efficiency improvement of the cell string 14 and may even cause a decrease in the efficiency of the cell string 14.

In the above embodiments, as shown in FIG. 1 and FIG. 4, the photovoltaic module 1 further includes an electrode line 26. The cells 15 and the busbar are electrically connected through the electrode line 26. The electrode lines 26 on the adjacent cell strings 15 along the width direction Y of the photovoltaic module 1 in the cell string group are provided on the same side of the cells 15 along the thickness direction of the photovoltaic module 1, so that the adjacent cell strings 14 along the width direction Y of the photovoltaic module 1 in the cell string group are connected in parallel, thereby reducing the current in a single cell string 14, reducing the power loss of a single cell string 14, and improving the overall power of the photovoltaic module 1.

In the above-mentioned embodiment, as shown in FIG. 1 and FIG. 4, the four battery strings 14 in the cell string group can be arranged in an array along the length direction X and the width direction Y of the photovoltaic module 1, so that the shape size of the photovoltaic module 1 in this embodiment is the same as that of the conventional module, thereby enabling the photovoltaic module 1 in this embodiment to be produced or assembled without special processes or steps, and reducing the difficulty of production or assembling.

The above are merely exemplary embodiments of the present disclosure, which, as mentioned above, are not used to limit the present disclosure. Any modification, equivalent substitution, improvement, etc., shall fall into the protection scope of the present disclosure.

## Claims

1. A photovoltaic module (1), comprising three cell string groups connected in series,
wherein each cell string group of the three cell string groups comprises four cell strings (14) connected in parallel;
one cell string of the four cell strings (14) comprises cells (15) electrically connected to each other, which are quarter cells (15) formed by cutting a whole cell (15); and
a length of the cell (15) is represented as L1, and a width of the cell (15) is represented as L2, where 46.675mm ≤ L2 ≤ 53.25mm.

2. The photovoltaic module (1) according to claim 1, wherein a number of solar cells (15) in each cell string (14) is the same.

3. The photovoltaic module (1) according to claim 2, wherein the four cell strings (14) in each of the three cell string groups are arranged in an array along a length direction of the photovoltaic module (1) and a width direction of the photovoltaic module (1), respectively.

4. The photovoltaic module (1) according to claim 3, wherein two cell strings (14) that are adjacent to each other along the length direction of the photovoltaic module (1) are electrically connected to each other through a first busbar (16);
wherein the three cell string groups comprise a first cell string group (11), a second cell string group (12), and a third cell string group (13); and the photovoltaic module (1) further comprises a second busbar (17) and a third busbar (18), the first cell string group (11) and the second cell string group (12) are connected in series through the second busbar (17) and the third busbar (18); and
wherein the photovoltaic module (1) further comprises a fourth busbar (19) and a fifth busbar (20), and along the length direction of the photovoltaic module (1), two ends of the third cell string group (13) are respectively electrically connected to the fourth busbar (19) and the fifth busbar (20), and each of the fourth busbar (19) and the fifth busbar (20) is electrically connected to the first bustbar (16) located in the first cell string group (11) or the second cell string group (12).

5. The photovoltaic module (1) according to claim 4, wherein a first lead wire (21) is further provided between the second cell string group (12) and the third cell string group (13),
wherein the first lead wire (21) is electrically connected to the fourth busbar (19) and the fifth busbar (20), and the first lead wire (21) is also electrically connected to the first busbar (16) located in the second cell string group (12).

6. The photovoltaic module (1) according to claim 5, wherein a second lead wire (22) is further provided between the first cell string group (11) and the second cell string group (12); and the second lead wire (22) is electrically connected to the second busbar (17) and the third busbar (18);
wherien the photovoltaic module (1) further comprises a first bypass diode (23), a second bypass diode (24), and a third bypass diode (25); and
the first cell string group (11) is connected in reverse parallel with the first bypass diode (23) through the second lead wire (22), the second cell string group (12) is connected in reverse parallel with the second bypass diode (24) through the second lead wire (22), and the third cell string group (13) is connected in reverse parallel with the third bypass diode (25) through the first lead wire (21).

7. The photovoltaic module (1) according to claim 6, wherein first busbar (16) is further provided with a lead-out end (161) perpendicular to the first busbar (16), and the lead-out end (161) is in an "L" shape relative to the first busbar (16).

8. The photovoltaic module (1) according to claim 7, wherein the first busbar (16) and the lead-out end (161) in the second cell string group are an integrally formed structure, and
along a thickness direction Z of the photovoltaic module, the first lead wire 21 is located on the upper surface of the first busbar 16 and abuts with the side wall of the lead-out end (161).

9. The photovoltaic module (1) according to claim 7, wherein the first busbar (16) and the lead-out end (161) in the second cell string group are separated from each other, and
along a thickness direction Z of the photovoltaic module, the first lead wire (21) is located between the lead-out end (161) and the first busbar (16).

10. The photovoltaic module (1) according to claim 6, wherein a first insulation layer (27) is provided between the first lead wire (21) and the cell (15), and a second insulation layer is provided between the second lead wire (22) and the cell (15).

11. The photovoltaic module (1) according to claim 10, wherein a surface area of the first insulation layer is greater than a surface area of the first lead wire (21), and a surface area of the second insulation layer is greater than a surface area of the second lead wire (22).

12. The photovoltaic module (1) according to claim 1, wherein, along a width direction of the photovoltaic module (1), a spacing L3 between adjacent cell strings (14) satisfies 1.4mm ≤ L3 ≤ 1.6mm; and
along a length direction of the photovoltaic module (1), adjacent solar cells (15) have an overlapping area, and a length L4 of the overlapping area satisfies 0.2 mm ≤ L4 ≤ 0.4 mm.

13. The photovoltaic module (1) according to claim 1, further comprising electrode lines (26), wherein the solar cell (15) and the busbar are electrically connected to each other through the electrode lines (26), and the electrode lines (26) on adjacent cell strings (14) along a width direction of the photovoltaic module (1) in each of the three cell string groups are arranged on a same side of the solar cell (15) along a thickness direction of the photovoltaic module (1).

14. The photovoltaic module (1) according to claim 6, wherein along the width direction Y of the photovoltaic module, a width L5 of the first lead wire (21) and the second lead wire (22) satisfies 4 mm ≤ L5 ≤ 8 mm.

15. The photovoltaic module (1) according to claim 10, along the width direction Y of the photovoltaic module, a width L6 of the first insulation layer (27) and the second insulation layer 28 satisfies 8 mm ≤ L6 ≤ 18 mm.
